# EUROPEAN PATENT APPLICATION

(11) **EP 4 848 745 A1**
(43) Date of publication of application: **02.12.2026**
(21) Application number: 25791532.2
(22) Date of filing: 24.07.2025
(51) Int. Cl.: H04N 23/957, H04N 23/54, H04N 23/55, G02B 3/00

(54) **MICROLENS ARRAY-BASED WIDE-FIELD CAMERA DEVICE AND MANUFACTURING METHOD THEREFOR**

(30) Priority: 11.03.2025 KR 20250031406
(71) Applicant: Korea Advanced Institute Of Science And Technology, Daejeon, 34141 (KR)
(72) Inventor: JEONG, Ki-Hun, Daejeon 34141 (KR); KWON, Jaemyeong, Daejeon 34141 (KR); CHA, Younggil, Daejeon 34141 (KR)
(74) Representative: Manitz Finsterwald Patent- und Rechtsanwaltspartnerschaft mbB
(86) International application number: PCT/KR2025/010966
(87) International publication number: WO 2026/192118

(57) **Abstract**

A microlens array-based wide field-of-view camera device and a method for manufacturing the same are disclosed. The device includes a first microaperture formed on a first surface of the wafer and a second microaperture formed on a second surface of the wafer opposite the first surface. The second microaperture includes one or more pores that allow light passing through the wafer to pass to the outside. The device further includes a microlens array including a plurality of microlenses formed on pores of the second microaperture, and an image sensor supported on a side of the second microaperture through a spacer to detect light entering through the microlens array and generate a corresponding electrical image signal. The microlenses each refract light entering through the wafer to form a focus on the image sensor. Some or all of the microlenses are ellipsoidal microlenses.

## Description

### [Technical Field]

### (a) Field

The present disclosure relates to a wide field-of-view camera device based on a microlens array and a method for manufacturing the same.

### [Background Art]

A conventional wide field-of-view imaging technology is primarily directed to a design and fabrication method of multiple lens groups for optimizing wide field-of-view lenses, or to a method of acquiring wide field-of-view images through appropriate image processing by using multiple cameras or by spatially scanning a single camera.

Such methods involve complex design and manufacturing processes, which pose challenges to miniaturization and mass production, or result in increased manufacturing costs. In addition, in order to develop products with various fields of view, it is necessary to newly carry out both optical and mechanical design processes.

Although wide field-of-view imaging is required in various fields, conventional methods are difficult to apply in confined spaces or compact platforms.

Camera devices incorporating folding mirrors, prism arrays, curved lenses, and image sensors have been developed for miniaturized wide field-of-view imaging platforms, but such devices still require multiple complex optical components and image sensors, or rely on curved image sensors instead of conventional planar ones, thereby limiting their versatility and performance.

Meanwhile, a camera device based on a microlens array can be manufactured in an ultra-thin form using wafer-level processes, and is capable of imaging both near and far fields. In particular, a resolution in a near field is superior to that of a conventional camera device.

However, a conventional system is generally formed of a single-layer spherical lens, various optical aberrations such as field curvature and astigmatism caused by off-axis light components occur severely, resulting in significant degradation of resolution in wide field-of-view imaging scenarios.

### [Disclosure]

### [Technical Problem]

The present disclosure attempts to provide a microlens array-based wide field-of-view camera device and a method for manufacturing the same, which enable realization of a wide field-of-view imaging platform that is suitable for ultra-compact fabrication and mass production.

### [Technical Solution]

To achieve the above-described object of the present disclosure and to realize the characteristic effects described below, the distinctive configuration of the present disclosure is as follows.

According to an aspect of the present disclosure, a wide field-of-view camera device is provided, the device including
a first microaperture formed on a first surface of a wafer made of a transparent material that allows light to pass through, a second microaperture formed on a second surface opposite to the first surface of the wafer, wherein the second microaperture includes one or more pores that allow light passing through the wafer to pass to an outside, a microlens array configured to include a plurality of microlenses formed on the pores of the second microaperture, and an image sensor supported through a spacer on a side of the second microaperture, and configured to detect light entering through the microlens array and generate a corresponding electrical image signal, wherein the microlenses each refract light entering through the wafer to form a focus on the image sensor, and some or all of the microlenses are ellipsoidal microlenses.

Herein, the ellipsoidal microlens has an asymmetrical focal length to reduce astigmatism occurring at an angle of incidence greater than a certain level.

In addition, a size of the ellipsoidal microlens is set such that both a tangential focal plane, formed based on a major-axis radius of curvature, and a sagittal focal plane, formed based on the minor-axis radius of curvature, coincide with the image sensor plane.

In addition, a field of view of each of the microlenses is adjusted according to a distance between the first microaperture and the second microaperture, and a diameter of the first microaperture and a diameter of the second microaperture.

In addition, the microlenses of the microlens array are arranged on the second surface according to one of a circular arrangement and a rectangular arrangement.

In addition, when the microlenses of the microlens array are arranged in a plurality of circular arrangements, the microlens positioned at a center of the circular arrangements is a spherical microlens, and a microlens further away from the spherical microlens has a larger radius of curvature than that of a microlens relatively closer to the spherical microlens.

According to another aspect of the present disclosure, a method for manufacturing a wide-field-of-view camera device is provided, the method including
forming a first microaperture on a first surface of a wafer made of a transparent material capable of transmitting light, and forming a second microaperture on a second surface opposite to the first surface of the wafer wherein each second microaperture includes one or more pores configured to allow light passing through the wafer to exit externally, patterning a thermoplastic photoresist on each of the one or more pores of the second microaperture, forming a plurality of microlenses using a thermal reflow process for the thermoplastic photoresist, and performing packaging the wide field-of-view camera device by attaching an image sensor to a side of the second microaperture of the wafer using a spacer, wherein, in the packaging, the packaging is performed to form a focus on the image sensor by allowing the microlenses each to refract light entering through the wafer, and some or all of the microlenses are ellipsoidal microlenses.

Herein, the forming includes depositing a metal layer on each of the first and second surfaces of the wafer, and forming the first microaperture and the second microaperture through a lift-off process for the metal layer.

In addition, the thermoplastic photoresist is patterned into an ellipsoidal microcylinder shape in the patterning.

In addition, a size of the ellipsoidal microlens is set such that both a tangential focal plane, formed based on a major-axis radius of curvature, and the sagittal focal plane, formed based on a minor-axis radius of curvature, coincide with the image sensor plane.

According to another aspect of the present disclosure, a wide-field camera device is provided, the device including
a first microaperture formed on a first surface of a wafer made of a transparent material capable of transmitting light, wherein the first microaperture includes one or more pores configured to allow light to pass through the first surface of the wafer, a second microaperture formed on a second surface opposite to the first surface of the wafer, wherein the second microaperture includes one or more pores that allow light passing through the wafer to pass to an outside, a first microlens array configured to include a plurality of first microlenses formed on the pores of the first microaperture, a second microlens array configured to include a plurality of second microlenses formed on the pores of the second microaperture, and an image sensor supported through a spacer on a side of the second microaperture, and configured to detect light entering through the second microlens array and generate a corresponding electrical image signal, wherein the second microlenses each refract light entering through the wafer to form a focus on the image sensor, the first microlenses are cylindrical microlenses, and the second microlenses are spherical microlenses or ellipsoidal microlenses.

Herein, the cylindrical microlenses have refractive power in a specific direction. reducing astigmatism occurring at an angle of incidence greater than a certain level.

In addition, a curvature of the first microlenses is configured such that the tangential focal length and the sagittal focal length are equal. to eliminate astigmatism.

In addition, a field of view of each of the second microlenses is adjusted according to a size of the first microlenses, a distance between the first microaperture and the second microaperture, a diameter of the first microaperture, and a diameter of the second microaperture.

In addition, the first microlenses of the first microlens array and the second microlenses of the second microlens array are arranged in either a circular arrangement or a rectangular arrangement, and an arrangement pattern of the first microlenses and an arrangement pattern of the second microlenses are identical.

In addition, no first microlens is formed on a central pore among the pores of the first microaperture, and a microlens positioned farther from the central pore is larger than a microlens positioned relatively closer to the central pore.

According to another aspect of the present disclosure, a method for manufacturing a wide-field camera device is provided, the method including
forming a first microaperture on a first surface of a wafer made of a transparent material capable of transmitting light, and forming a second microaperture on a second surface opposite to the first surface of the wafer wherein the first microaperture and the second microaperture each include one or more pores to allow light to pass through the wafer, patterning a first thermoplastic photoresist on each one or more pores of the first microaperture, and patterning a second thermoplastic photoresist on each one or more pores of the second microaperture, wherein the first thermoplastic photoresist is not patterned in a central pore among the pores of the first microaperture, forming the first microlenses using a thermal reflow process for the first thermoplastic photoresist, and forming the second microlenses using the thermal reflow process for the second thermoplastic photoresist, and performing packaging using the wide field-of-view camera device by attaching an image sensor to a side of the second microaperture of the wafer using a spacer, wherein, in the packaging, the packaging is performed to form a focus on the image sensor by allowing the second microlenses each to refract light entering through the wafer, the first microlenses are cylindrical microlenses, and the second microlenses are spherical microlenses or ellipsoidal microlenses.

Herein, the forming includes depositing a metal layer on each of the first and second surfaces of the wafer, and forming the first microaperture and the second microaperture through a lift-off process for the metal layer.

In addition, a curvature of the first microlenses is set such that a tangential focal length of each of the of first microlenses and a sagittal focal length of each of the first microlenses are the same.

### [Advantageous Effects]

According to the embodiment of the present disclosure, a microlens array-based wide field-of-view camera device may be provided, which offers a wide field-of-view imaging platform suitable for ultra-compact fabrication and mass production.

Additionally, it may be manufactured in an ultra-thin form (total track length < 2 mm), which may drastically reduce a system size compared to conventional methods using wide field-of-view lenses and multiple cameras.

In addition, a short focal length of the microlens allows for optimization to simultaneously capture images from ultra-close-up (< 5 mm) to long lengths, while the small system size allows for wide field-of-view imaging in a variety of shooting environments.

### [Description of the Drawings]

FIG. 1 illustrates a schematic diagram showing a configuration of a microlens array-based wide field-of-view camera device according to an embodiment of the present disclosure.
FIG. 2 illustrates a microlens array (a), a single microlens (b), and respective focal lengths (c) as shown in FIG. 1.
FIG. 3 illustrates an arrangement of a microlens array in a microlens array-based wide field-of-view camera device according to an embodiment of the present disclosure.
FIG. 4 illustrates a schematic flowchart showing a method for manufacturing a microlens array-based wide field-of-view camera device according to an embodiment of the present disclosure.
FIG. 5 illustrates a schematic diagram showing a manufacturing process of a microlens array-based wide field-of-view camera device according to an embodiment of the present disclosure.
FIG. 6 illustrates a plan view showing a patterned state of an ellipsoidal pillar structure on a lower surface of a wafer, which is oriented upward, in a microlens array-based wide field-of-view camera device according to an embodiment of the present disclosure.
FIG. 7 illustrates a schematic diagram showing a configuration of a microlens array-based wide field-of-view camera device array according to another embodiment of the present disclosure.
FIG. 8 illustrates an example of a partial arrangement of a first microlens array (a) and a second microlens array as shown in FIG. 7.
FIG. 9 illustrates an example of a rectangular arrangement (a) of the first microlens array and a rectangular arrangement (b) of the second microlens array, as shown in FIG. 7.
FIG. 10 illustrates a schematic flowchart showing a method for manufacturing a microlens array-based wide field-of-view camera device according to another embodiment of the present disclosure.
FIG. 11 illustrates a schematic diagram showing a manufacturing process of a microlens array-based wide field-of-view camera device according to another embodiment of the present disclosure.
FIG. 12 illustrates a schematic plan view showing a manufacturing process of a microlens array-based wide field-of-view camera device according to another embodiment of the present disclosure.
FIG. 13 illustrates a wide field-of-view image obtained by a microlens array-based camera device according to another embodiment of the present disclosure, wherein (a) represents an image array captured through a microlens array, and (b) represents a wide-field-of-view image obtained through stitching for the image array of (a).

### [Mode for Disclosure]

Hereinafter, embodiments of the present disclosure will be described in detail with reference to the accompanying drawings, so that those skilled in the art to which the present disclosure pertains may readily implement the disclosure. However, as those skilled in the art would realize, the described embodiments of the present disclosure may be modified in various different ways, all without departing from the spirit or scope of the present disclosure. To clearly describe the disclosure in the drawings, unrelated descriptions have been omitted. Throughout the entire specification, similar parts are assigned similar reference numerals.

In the following description, reference numerals and names are provided for convenience of description, and the devices are not necessarily limited to such numerals or names.

In the following description, unless explicitly described to the contrary, the word "comprise" and variations such as "comprises" or "comprising" will be understood to imply the inclusion of stated elements but not the exclusion of any other elements. In addition, the terms "-er", "-or", and "module" described in the specification mean units for processing at least one function and operation, and can be implemented by hardware components or software components, and combinations thereof.

In the following description, expressions written in the singular may be construed in the singular or plural unless an explicit expression such as "one" or "single" is used. Terms including ordinal numbers such as first, second, and the like will be used only to describe various component and are not to be interpreted as limiting these components. These terms may be used for the purpose of distinguishing one constituent element from other constituent elements.

In a flowchart described with reference to the drawings, an order of operations may be changed, several operations may be merged, some operations may be decomposed, and specific operations may not be performed.

Hereinafter, a microlens array-based wide field-of-view camera device based on a microlens array according to an embodiment of the present disclosure will be described.

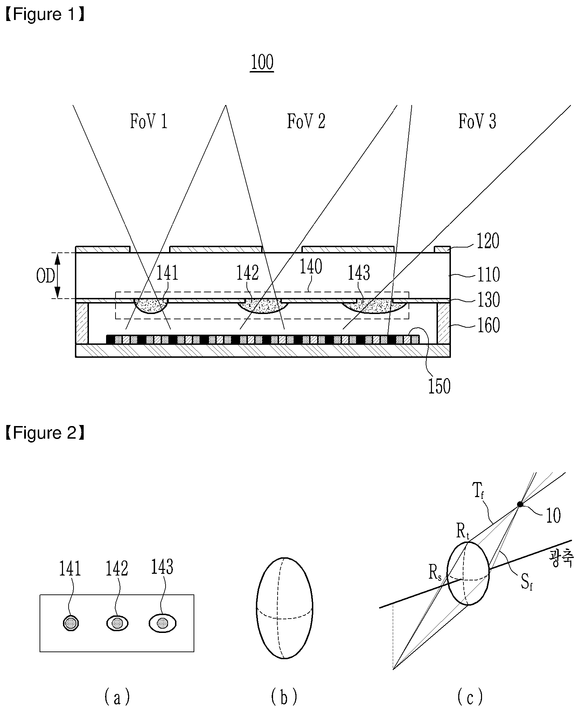

FIG. 1 illustrates a schematic diagram showing a configuration of a microlens array-based wide field-of-view camera device 100 according to an embodiment of the present disclosure.

As illustrated in FIG. 1, the microlens array-based wide field-of-view camera device 100 according to an embodiment of the present disclosure may include a wafer 110, a first microaperture 120, a second microaperture 130, a microlens array 140, an image sensor 150, and a spacer 160.

The wafer 110 is a wafer made of a transparent material that allows light to pass through. For example, the wafer 110 may be a substrate made of transparent glass.

The first microaperture 120 is formed on a first surface of the wafer 110, e.g., an upper surface of the wafer 110 as shown in FIG. 1, and it absorbs or reflects some of light incident from the outside, i.e., from an upper portion of the wafer 110, and allows remaining light to pass toward a lower portion of the wafer 110. To this end, the first microaperture 120 includes one or more pores through which light may pass.

The second microaperture 130 is formed on the second surface of the wafer 110, e.g., a lower surface of the wafer 110 in FIG. 1, and it absorbs some of the light passing through the wafer 110, and transmits remaining light toward the image sensor 150. To this end, the second microaperture 130 includes one or more pores through which light may pass.

The microlens array 140 may have a structure in which a plurality of micro-scale microlenses 141, 142, and 143 are arranged, and may include microlenses arranged in, e.g., a circular pattern, a quadrangular pattern, etc. Each of the microlenses 141, 142, and 143 is aligned with the double-layer aperture, i.e., the first microaperture 120 and the second microaperture 130, and has a convexly protruding shape. In particular, in the embodiment of the present disclosure, each of the microlenses 142 and 143 is an ellipsoidal microlens having an asymmetrical focal length, and the microlens 141 is a spherical microlens. This will be described in detail later.

Each of the microlenses 141, 142, and 143 refracts light entering through the wafer 110 to form a focal point on the image sensor 150, and in this case, the light that has passed through both the first microaperture 120 and the second microaperture 130 is received.

Each of the microlenses 141, 142, and 143 has a partial field of view (FoV) that is determined by the positions of the first microaperture 120 and the second microaperture 130. Referring to FIG. 1, each of three microlenses 141, 142, and 143 may include a respective field of view (FoV1, FoV2, and FoV3), and such partial fields of view may be determined by a width between the first microaperture 120 and the second microaperture 130 offset from optical axes of the microlenses, an offset distance OD between the first and second microaperture 120 and 130, and a distance between the microlenses 141, 142, and 143 and the image sensor 150. Herein, the aforementioned three microlenses 141, 142, and 143 are merely exemplary elements selected for ease of description from among a plurality of microlenses arranged in a circular or rectangular pattern. In addition, when the three microlenses 141 are part of a microlens array arranged in a same circular or rectangular pattern, each microlens has a same curvature radius, but if the microlenses belong to different circular or rectangular patterns, their respective curvature radii may differ. For example, the microlens 141 positioned at a center may have a spherical shape, and the microlenses 142 and 143 positioned farther from the center may have larger curvature radii. For example, the microlens 143 that is relatively far from the microlens 141 has a larger radius of curvature than that of the microlens 142 that is relatively close to the microlens 141. Herein, the radius of curvature refers to both a major axis radius of curvature and a minor axis radius of curvature.

The image sensor 150 senses light entering through the microlens array 140 and outputs an electrical image signal. The image sensor 150 may be, e.g., a complementary metal oxide silicon (CMOS) image sensor, but the present disclosure is not limited thereto. The image sensor 150 may be a monochromatic sensor or a chromatic (RGB) sensor. When the image sensor 150 is an RGB sensor, the image sensor 150 may detect light corresponding to a red channel, a green channel, and a blue channel through an RGB color filter and output a signal indicating intensity of the corresponding color. Herein, although one image sensor 150 is shown to acquire an image array formed by three microlenses 141, 142, and 143, this is merely an example, and more than one image sensor, for example, a number of image sensors corresponding to the number of microlenses 141, 142, and 143, may be used.

The spacer 160 separates the microlens array 140 and the image sensor 150 to form a focal length. Specifically, the spacer 160 is placed between the second surface, i.e., a lower surface, of the wafer 110 and the image sensor 150.

Meanwhile, a central angle of a partial field of view corresponding to each of the microlenses 141, 142, and 143 may be determined based on an offset distance between the first microaperture 120 and the second micro-aperture 130. For example, when a central viewing direction is aligned with the front (incident angle: 0°), the offset distance between the first microaperture and the second microaperture would be zero.

For instance, when a desired central viewing angle is 45°, an offset distance of approximately 290 µm is required between the first and second microapertures in a case of using a 0.5 mm-thick wafer 110. That is, the central viewing angle shifts in the direction of the offset between the first and second micro-apertures.

These values may vary depending on the thickness of the wafer 110 and sizes of the apertures 120 and 130, and the partial field of view assigned to a single microlens 141 may be determined through optical simulation based on a dual-layer aperture design, including parameters such as the offset distance, the diameter of the first microaperture 120, and the diameter of the second microaperture 130.

For example, the central viewing angle of the single microlens 141, 142, or 143 may be set within a range of 0 to 70°. Alternatively, the field of view of the single microlens 141, 142, or 143 may be configured within a range of 0° to 90°. Alternatively, when the central viewing angle is set to 45° and the field of view is 30°, the corresponding microlens 141, 142, or 143 may receive incident light within a range of 30° to 60°.

As such, by arranging microlenses 141 with different central viewing angles and partial fields of view in a two-dimensional array, a wide field-of-view image with a field of view of up to 150° may be obtained through image stitching.

Hereinafter, each of the microlenses 141, 142, and 143 constituting the aforementioned microlens array 140 will be described in detail. The microlenses 141, 142, and 143 included in the microlens array 140 are configured to have different refractive powers along tangential and sagittal directions, and the tangential and sagittal focal lengths may be identical or vary depending on a position thereof, but all microlenses are ellipsoidal in shape, microlens 142 will be described as a representative example for convenience of description. In this context, when the microlens array 140 includes multiple microlenses 141, 142, and 143 arranged in a circular or rectangular configuration, the microlens positioned along a central axis, namely, the one oriented toward a front direction, such as the microlens 141, may be formed with a spherical geometry.

FIG. 2 illustrates the microlens array 140 (a), the single microlens 141, 142, or 143 (b), and respective focal lengths (c) as shown in FIG. 1.

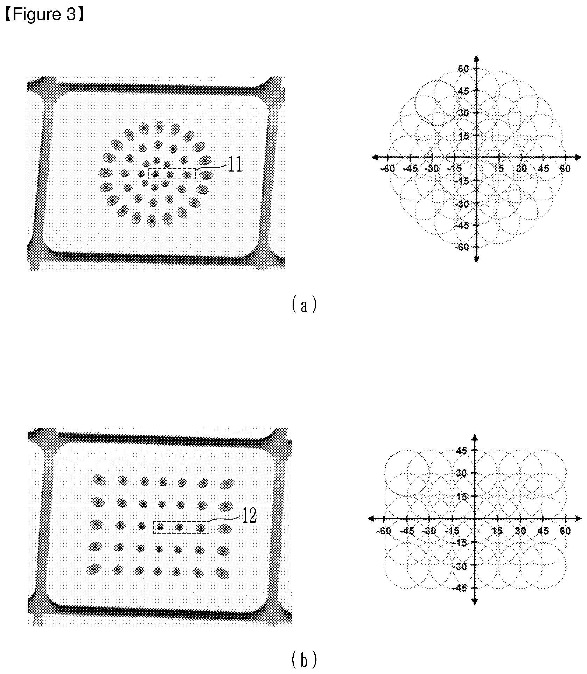

Referring to FIG. 2(a), the three microlenses 141, 142, and 143 are included in the microlens array 140 among the microlenses arranged in a circular or rectangular pattern. Such arrangements are merely exemplary, and the present disclosure is not limited to the two configurations shown in FIG. 3, namely, a circular arrangement (see (a)) and a rectangular arrangement (see (b)), and rather, the technical scope of the present disclosure encompasses various other types of microlens arrangements beyond the aforementioned two.

In FIG. 3(a) and (b), the diagrams shown on the right represent the partial fields of view corresponding to the microlens arrangements illustrated on the left. The aforementioned microlens array 140 corresponds to a partial arrangement 11 shown in FIG. 3(a) and a partial arrangement 12 shown in FIG. 3(b).

Referring to FIG. 2(b) and (c), the microlenses 142 and 143 have an ellipsoidal shape, and therefore possess different curvature radii along a mutually orthogonal major axis (Rₜ) and minor axis (Rₛ). Specifically, the curvature radius along the major axis (Rₜ) is greater than that along the minor axis (Rₛ). That is, Rₜ is greater than Rₛ. In this example, the major-axis curvature radius Rₜ and the minor-axis curvature radius Rₛ of the microlenses 142 and 143 may range, e.g., from 10 µm to 2000 µm

More specifically, for example, referring to FIG. 2(a), the microlens 142 has an ellipsoidal shape, and for example, its major-axis curvature radius Rₜ may be 324.3 µm and its minor-axis curvature radius Rₛ may be 302.9 µm, and it may be seen that both curvature radii Rₜ and Rₛ of microlens 142 are greater than those of microlens 141. Additionally, the microlens 143 also has an ellipsoidal shape, and for example, its major-axis curvature radius Rₜ may be 505.5 µm and its minor-axis curvature radius Rₛ may be 364.2 µm, and it may be seen that both curvature radii Rₜ and Rₛ of the microlens 143 are greater than those of the microlenses 141 and 142.

Referring to FIG. 2(c), in the embodiment of the present disclosure, the microlenses 142 and 143 are configured such that the tangential focal length T_{f}, based on the major-axis curvature radius Rₜ, and the sagittal focal length Sf, based on the minor-axis curvature radius Rₛ, are matched to form a single focal point 10, and accordingly, the curvature radii Rₜ and Rₛ are set to achieve this alignment. In this case, two focal lengths T_{f} and S_{f} may be determined based on a distance between the microlenses 142 and 143 and the image sensor 150. Herein, the tangential focal length T_{f} and the sagittal focal length S_{f}, or in the case of a spherical microlens, the omnidirectional focal length, may range from 50 µm to 5000 µm.

Meanwhile, to eliminate astigmatism that increases with the central viewing angle, the focal length in the direction of the spatial offset must be increased. That is, when a height of the microlenses 142 and 143 is constant, an increase in the length or diameter of the major and minor axes results in a longer focal length. In this case, the major-axis curvature radius Rₜ and the minor-axis curvature radius Rₛ for optimally eliminating astigmatism at a specific incident angle may be determined through optical simulation, and the microlenses 142 and 143 exhibit following characteristics in terms of their curvature radii Rₜ and Rₛ.
- An aspect ratio (minor axis length / major axis length) of the ellipsoidal microlenses 142 and 143, which is optimized to eliminate astigmatism at a specific incident angle, may be determined within a range of 0.1 to 1.0, where 1.0 corresponds to a spherical lens.
- Astigmatism occurring at specific central viewing angles within the range of 0° to 75° may be effectively eliminated by adjusting the aspect ratio of the ellipsoidal microlenses 142 and 143.

As such, in the embodiment of the present disclosure, the tangential focal length T_{f} and the sagittal focal length S_{f} of the microlenses 142 and 143 are matched for wide field-of-view incident light, thereby forming a single focal point and preventing degradation in imaging quality due to astigmatism. Meanwhile, the tangential focal length T_{f} and the sagittal focal length S_{f}, determined at this stage, may be optimized through optical simulation not only to eliminate astigmatism but also to correct field curvature that varies with an incident angle.

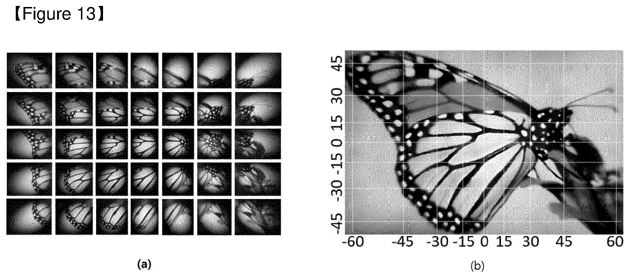

Additionally, by merging the images formed through each of the microlenses 141, 142, and 143 included in the microlens array 140, a wide field-of-view image may be ultimately obtained. For example, FIG. 13 illustrates a wide field-of-view image acquired by a microlens array-based wide field-of-view camera device according to another embodiment of the present disclosure. In FIG. 13(a) illustrates an array of partial images captured through the microlens array 140, and (b) shows a wide field-of-view image obtained by stitching the partial image array shown in (a).

As illustrated in FIG. 13, according to an embodiment of the present disclosure, a wide field-of-view image may be obtained by merging a plurality of partial images captured through the microlens array 140.

Next, a method for manufacturing the wide field-of-view camera device 100 based on a microlens array according to an embodiment of the present disclosure will be described.

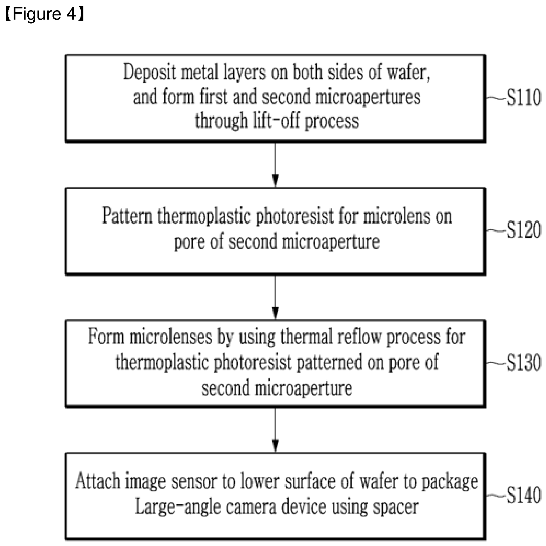

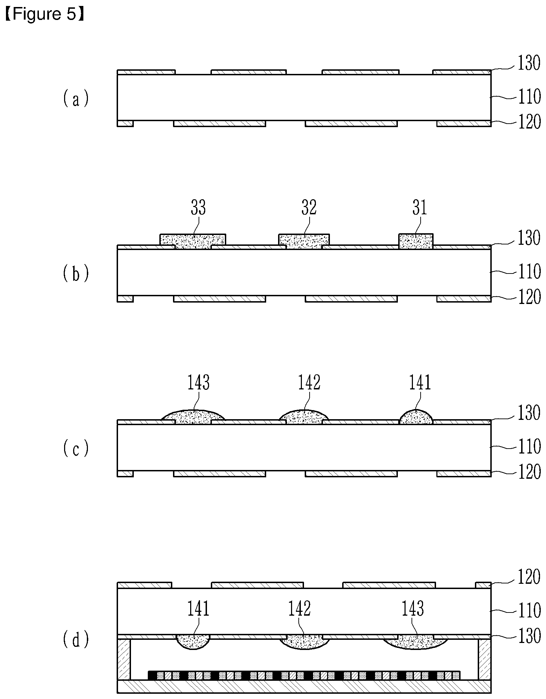

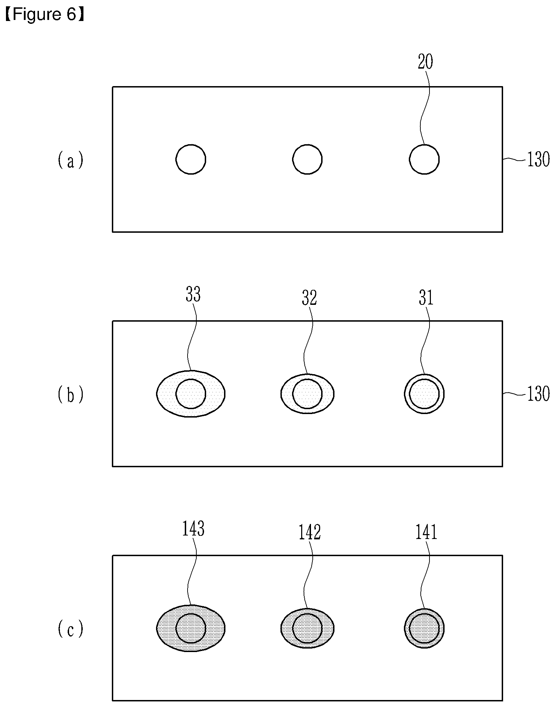

FIG. 4 illustrates a schematic flowchart showing a method for manufacturing the microlens array-based wide field-of-view camera device 100 according to an embodiment of the present disclosure, FIG. 5 illustrates a schematic side view showing a manufacturing process of the microlens array-based wide field-of-view camera device 100 according to an embodiment of the present disclosure, and FIG. 6 illustrates a schematic plan view showing a manufacturing process of the microlens array-based wide field-of-view camera device 100 according to an embodiment of the present disclosure.

Referring to FIG. 4 and FIG. 5(a), first, metal layers (e.g., chromium (Cr)) are deposited on opposite surfaces of the wafer 110, namely, the first surface (upper surface) and the second surface (lower surface), and then the first and second microapertures 120 and 130 are formed through a lift-off process (S110). Herein, the second microaperture 130 is formed on the first surface (upper surface) of the wafer 110, and the first microaperture 120 is formed on the second surface (lower surface) of the wafer 110.

FIG. 6(a) illustrates a plan view of the wide field-of-view camera device 100 shown in FIG. 5(a), and a pore 20 represents a gap formed within the second microaperture 130.

The step S110 may be performed, specifically, through a thermoplastic photoresist application process, a metal (chrome) deposition process, a lift-off process, etc.

Subsequently, as shown in FIG. 5(b), thermoplastic photoresist materials 31, 32, and 33 for microlens are patterned on the pore 20 positioned within the second microaperture 130 (S120). In this case, as shown in FIG. 5(b), the patterned shapes of the thermoplastic photoresists 31, 32, and 33 may appear rectangular in the side view of the wafer 110, whereas in the plan view illustrated in FIG. 6(b), they are patterned as one circular column 31 and two elliptical columns 32 and 33. Herein, among the two elliptical column shapes 32 and 33, the left elliptical column 33 is positioned farther from the central circular column shape 31, and accordingly, it may be understood that it has a largest curvature radius.

Subsequently, referring to FIG. 5^{©}, microlenses 141, 142, and 143 are respectively formed by applying a thermal reflow process to a thermoplastic photoresist 30 for microlens patterned on a pore of the second microaperture 130 (S130). As shown in FIG. 5(c) and FIG. 6(c), the microlenses 141, 142, and thus formed include one spherical microlens 141 and two ellipsoidal microlenses 142 and 143. In this case, it may be understood that both the major-axis and minor-axis curvature radii of the ellipsoidal microlens 143 are greater than those of the ellipsoidal microlens 142.

Subsequently, the image sensor 150 is attached to a lower surface of the wafer 110, specifically to the second microaperture 130, using the spacer 160, thereby completing packaging of the microlens-based wide field-of-view camera device 100 (S140). Such packaging may be implemented by attaching the wafer 110 and the image sensor 150 using the spacer 160 through a flip-chip bonding process.

Next, a microlens array-based wide field-of-view camera device based on a microlens array according to another embodiment of the present disclosure will be described.

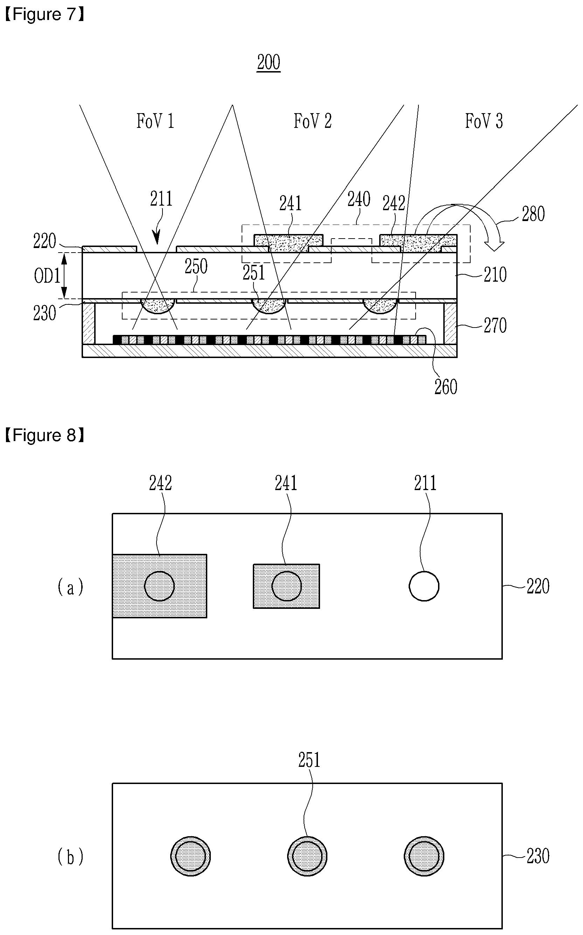

FIG. 7 illustrates a schematic diagram showing a configuration of a microlens array-based wide field-of-view camera device 200 according to another embodiment of the present disclosure.

As illustrated in FIG. 7, the microlens array-based wide field-of-view camera device 200 according to another embodiment of the present disclosure includes a wafer 210, a third microaperture 220, a fourth microaperture 230, a first microlens array 240, a second microlens array 250, an image sensor 260, and a spacer 270.

The wafer 210, the third microaperture 220, the fourth microaperture 230, the image sensor 260, and the spacer 270 are similar to the wafer 110, the first microaperture 120, the second microaperture 130, the image sensor 150, and the spacer 160 described with reference to FIGS. 1 through 6, so detailed descriptions thereof will be omitted, and differing aspects from the previously described wide field-of-view camera device 100 will be provided.

The first microlens array 240 have structure in which multiple cylindrical microlenses 241 and 242 are arranged, and may include cylindrical microlenses arranged in various patterns, such as a circular pattern or a rectangular pattern.

Each of the microlenses 241 and 242 is a cylindrical microlens and has a focal length in one direction on a plane. For example, the focal length in an x-axis direction may be 500 µm, while the focal length in a y-axis direction may be infinity. The curvature directions of the respective microlenses 241 and 242 are aligned with a direction 280 indicated in FIG. 7.

Each of the microlenses 241 and 242 is formed to protrude convexly between pores of the third microaperture 220, but in a circular or rectangular arrangement similar to that shown in FIG. 3, no microlens is formed over a central pore 211 of the third microaperture 220.

Each of the microlenses 241 and 242 refracts incoming light from outside the wafer 210 so as to direct it toward the second microlens array 250. Particularly, a curvature of each of the microlenses 241 and 242 is configured such that the tangential focal length and the sagittal focal length are equal, in order to eliminate astigmatism.

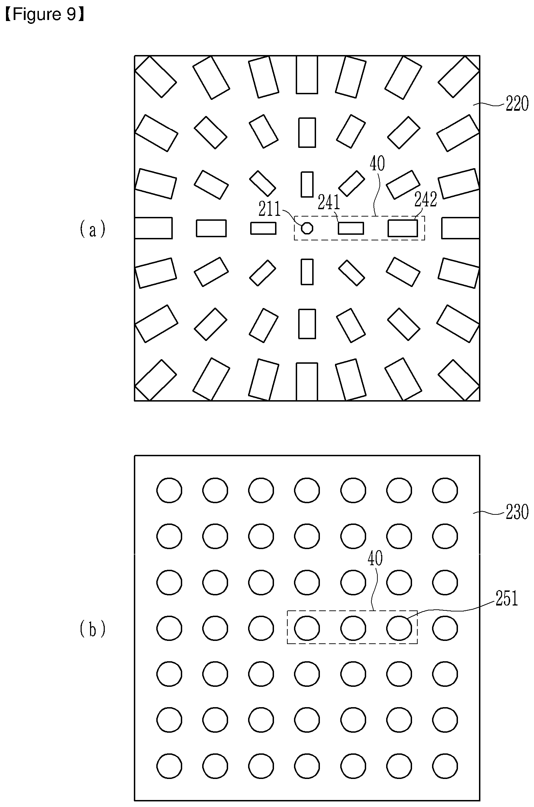

The second microlens array 250 may have a structure in which a plurality of micro-scale microlenses 251 are arranged, and may include microlenses arranged in, e.g., a circular pattern, a rectangular pattern, etc. In this case, an arrangement pattern of the second microlens array 250 is determined to correspond to an arrangement pattern of the first microlens array 240. Referring to FIG. 8, (a) illustrates an exemplary arrangement of the first microlens array 240, and (b) illustrates a corresponding arrangement of the second microlens array 250. Referring to FIG. 9, (a) illustrates an exemplary rectangular arrangement of the first microlens array 240, and (b) illustrates a corresponding rectangular arrangement of the second microlens array 250. In addition, the first microlens array 240 and the second microlens array 250 may adopt various arrangement patterns, such as a circular configuration as illustrated in FIG. 3

In these arrangements, it may be observed that the size of each microlens increases as its position moves farther from the center. For example, in FIG. 7, among the two microlenses 241 and 242 of the first microlens array 240, the microlens 242 is positioned farther from the central pore 211 than the microlens 241, and accordingly, it may be understood that the microlens 242 is larger in size than the microlens 241.

Each of the microlenses 251 is aligned with the double-layer aperture, i.e., the third microaperture 220 and the fourth microaperture 230, and has a convexly protruding shape. Particularly, in the embodiment of the present disclosure, each microlens 251 is a spherical microlens having a symmetrical focal length, but may alternatively be an ellipsoidal microlens.

Each of the microlenses 251 refracts light entering through the wafer 210 to form a focal point on the image sensor 260, and in this case, the light that has passed through both the third microaperture 220 and the fourth microaperture 230 is received.

Additionally, each microlens 251 has a partial field of view (FoV) that is determined by positions of the third microaperture 220 and the fourth microaperture 130. Referring to FIG. 7, each of the three microlenses 251 has a respective field of view (FoV1, FoV2, and FoV3), and these partial fields of view may be determined based on a distance between the third microaperture 220 and the fourth microaperture 230, which are offset by an equal distance from an optical axis of each microlens 251, an offset distance OD1 between the second microaperture 220 and the fourth microaperture 230, and the distance between each microlens 251 and the image sensor 260.

In addition, to eliminate astigmatism that increases with the central viewing angle, the focal length in the direction of the spatial offset must be increased.

Alternatively, a same effect may be achieved by reducing the focal length in a direction perpendicular to a direction in which the offset is applied.

Additionally, the cylindrical microlenses 241 and 242 may be configured to have curvature (refractive power) only in a direction perpendicular to the offset direction, thereby shortening the focal length in that direction and eliminating astigmatism.

These cylindrical microlenses 241 and 242 may have following characteristics.
- The lens length in the direction having curvature (i.e., refractive power) may range from 10 µm to 2000 µm.
- The focal length of the cylindrical microlenses 241 and 242 may range from 50 µm to 5000 µm.

Next, a method for manufacturing a wide field-of-view camera device 200 based on a microlens array according to another embodiment of the present disclosure will be described.

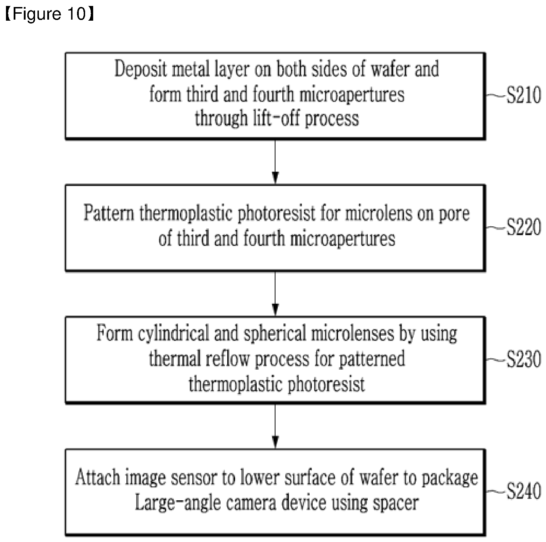

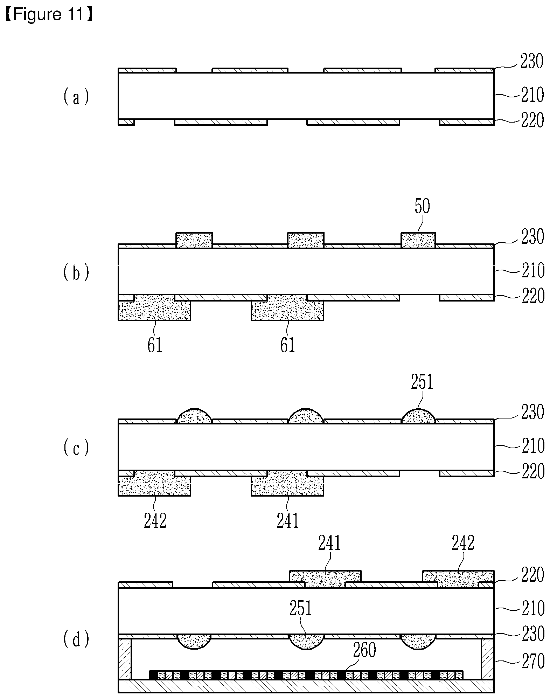

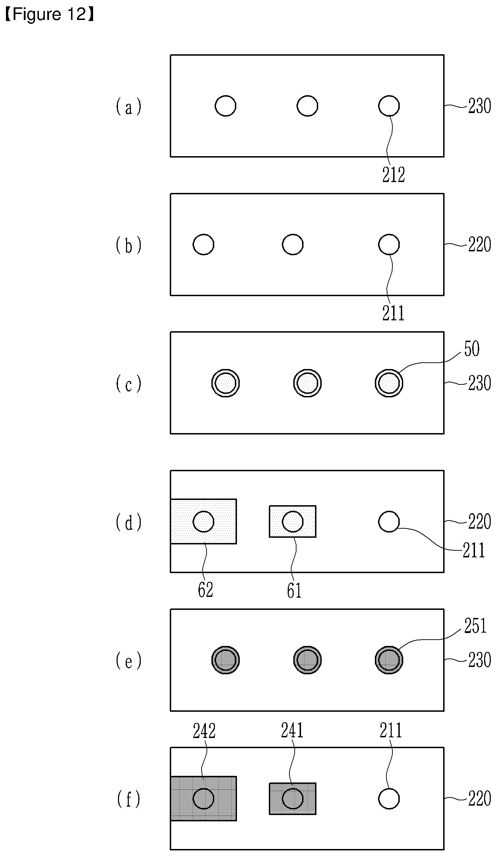

FIG. 10 illustrates a schematic flowchart showing a method for manufacturing the microlens array-based wide field-of-view camera device 200 according to another embodiment of the present disclosure, FIG. 11 illustrates a schematic side view showing a manufacturing process of a microlens array-based wide field-of-view camera device according to another embodiment of the present disclosure, and FIG. 12 illustrates a schematic plan view showing a manufacturing process of the microlens array-based wide field-of-view camera device 200 according to another embodiment of the present disclosure.

Referring to FIG. 10 and FIG. 11(a), first, metal layers (e.g., chromium (Cr)) are deposited on opposite surfaces of the wafer 210, namely, the first surface (upper surface) and the second surface (lower surface), and then the third and fourth microapertures 220 and 230 are formed through a liftoff process (S210). Herein, the fourth microaperture 230 is formed on the first surface (upper surface) of the wafer 210, and the third microaperture 220 is formed on the second surface (lower surface) of the wafer 110.

FIG. 12(a) illustrates a plan view of the wide field-of-view camera device 100 shown in FIG. 11(a), in which a pore 212 represents a pore within the fourth microaperture 230, and FIG. 12(b) illustrates a bottom view of the wide field-of-view camera device 100 shown in FIG. 11(a), in which a pore 211 represents a pore within the third microaperture 220.

The step S210 may be performed, specifically, through a thermoplastic photoresist application process, a metal (chrome) deposition process, a lift-off process, etc.

Next, referring to FIG. 11(b), a thermoplastic photoresist 50 for microlens is patterned on the pore 212 of the fourth microaperture 230, and thermoplastic photoresists 61 and 62 for microlens are also patterned on the pore 211 of the third microaperture 220 (S220). In this case, a patterned shape of the thermoplastic photoresist 50 may appear rectangular in a side view of the wafer 210, as shown in FIG. 11(b), while appearing as a cylindrical shape in a plan view illustrated in FIG. 12(c). Additionally, patterned shapes of the thermoplastic photoresists 61 and 62 may appear rectangular in the side view of the wafer 210 as shown in FIG. 11(b), and in the bottom view illustrated in FIG. 12(d). Herein, among the two rectangular shapes 61 and 62, the left-side shape 62 is positioned farther from the central pore 211 positioned on the right, and thus, it is larger in size than the central shape 61.

Subsequently, referring to FIG. 11(c), microlenses 241, 242, and 251 are respectively formed by applying a thermal reflow process to the thermoplastic photoresists 50, 61, and 62 (S230). Herein, the microlenses 241 and 242 are formed in a cylindrical shape, as illustrated in FIG. 12(f), whereas the microlens 251 is formed in a spherical shape, as depicted in FIG. 12(e).

Subsequently, the image sensor 260 is attached to an upper surface of the wafer 210, specifically to the fourth microaperture 230, using the spacer 270, thereby completing packaging of the microlens-based wide field-of-view camera device 200 (S240).

As described above, according to the embodiment of the present disclosure, a microlens array-based wide field-of-view camera device may be provided, which offers a wide field-of-view imaging platform suitable for ultra-compact fabrication and mass production.

Based on these characteristics, the present disclosure may be applied to various home appliances utilizing AI technologies, such as televisions, refrigerators, and robotic vacuum cleaners, and may be used for the following purposes. In this case, the ultra-compact wide field-of-view camera devices 100 and 200 according to the present disclosure are suitable for integration into various electronic products.

For example, when a user sits on a sofa in front of a television equipped with the ultra-compact wide field-of-view camera devices 100 and 200 according to the present disclosure, the motion may be detected to automatically turn on the television. Alternatively, when a person performs a specific motion, the motion may be detected and a corresponding function may be executed.

As another example, when a user approaches a refrigerator equipped with an ultra-small wide-field camera device 100 or 200 according to the present disclosure, the user may detect this and perform actions such as displaying specific information on a display.

In the above example, in response to increasing concerns regarding privacy protection and hacking risks, the wide field-of-view imaging may be performed to detect user movements across a broad area, while a camera resolution is intentionally reduced, (such as by hardware-level defocusing, so facial features are not recognizable and only silhouettes or general motion patterns are detectable), and this configuration may be modified or adapted accordingly.

The embodiments of the present disclosure described above are not limited to implementation through devices and methods, but may also be realized by a program that performs functions corresponding to the configuration of the embodiments, or by a recording medium on which such a program is stored.

While this disclosure has been described in connection with what is presently considered to be practical embodiments, it is to be understood that the disclosure is not limited to the disclosed embodiments, but, on the contrary, is intended to cover various modifications and equivalent dispositions included within the spirit and scope of the appended claims.

## Claims

1. A wide field-of-view camera device comprising:
a first microaperture formed on a first surface of a wafer made of a transparent material that allows light to pass through;
a second microaperture formed on a second surface opposite to the first surface of the wafer, wherein the second microaperture includes one or more pores that allow light passing through the wafer to pass to an outside;
a microlens array configured to include a plurality of microlenses formed on the pores of the second microaperture; and
an image sensor supported through a spacer on a side of the second microaperture, and configured to detect light entering through the microlens array and generate a corresponding electrical image signal,
wherein the microlenses each refract light entering through the wafer to form a focus on the image sensor, and
some or all of the microlenses are ellipsoidal microlenses,

2. The wide field-of-view camera device of claim 1, wherein
the ellipsoidal microlens has an asymmetrical focal length to reduce astigmatism occurring at an angle of incidence greater than a certain level.

3. The wide field-of-view camera device of claim 2, wherein
a size of the ellipsoidal microlens is set such that both a tangential focal plane, formed based on a major-axis radius of curvature, and a sagittal focal plane, formed based on the minor-axis radius of curvature, coincide with the image sensor plane.

4. The wide field-of-view camera device of claim 1, wherein
a field of view of each of the microlenses is adjusted according to a distance between the first microaperture and the second microaperture, and a diameter of the first microaperture and a diameter of the second microaperture.

5. The wide field-of-view camera device of claim 1, wherein
the microlenses of the microlens array are arranged on the second surface according to one of a circular arrangement and a rectangular arrangement.

6. The wide field-of-view camera device of claim 5, wherein
when the microlenses of the microlens array are arranged in a plurality of circular arrangements, the microlens positioned at a center of the circular arrangements is a spherical microlens, and
a microlens further away from the spherical microlens has a larger radius of curvature than that of a microlens relatively closer to the spherical microlens.

7. A manufacturing method for a wide field-of-view camera device, comprising:
forming a first microaperture on a first surface of a wafer made of a transparent material capable of transmitting light, and forming a second microaperture on a second surface opposite to the first surface of the wafer wherein each second microaperture includes one or more pores configured to allow light passing through the wafer to exit externally;
patterning a thermoplastic photoresist on each of the one or more pores of the second microaperture;
forming a plurality of microlenses using a thermal reflow process for the thermoplastic photoresist; and
packaging the wide field-of-view camera device by attaching an image sensor to a side of the second microaperture of the wafer using a spacer,
wherein, in the packaging, the packaging is performed to form a focus on the image sensor by allowing the microlenses each to refract light entering through the wafer, and
some or all of the microlenses are ellipsoidal microlenses.

8. The manufacturing method of claim 7, wherein
the forming includes depositing a metal layer on each of the first and second surfaces of the wafer, and forming the first microaperture and the second microaperture through a lift-off process for the metal layer.

9. The manufacturing method of claim 7, wherein
the thermoplastic photoresist is patterned into an ellipsoidal microcylinder shape in the patterning.

10. The manufacturing method of claim 7, wherein
a size of the ellipsoidal microlens is set such that both a tangential focal plane, formed based on a major-axis radius of curvature, and a sagittal focal plane, formed based on a minor-axis radius of curvature, coincide with on the image sensor plane.

11. A wide field-of-view camera device comprising
a first microaperture formed on a first surface of a wafer made of a transparent material capable of transmitting light, wherein the first microaperture includes one or more pores configured to allow light to pass through the first surface of the wafer;
a second microaperture formed on a second surface opposite to the first surface of the wafer, wherein the second microaperture includes one or more pores that allow light passing through the wafer to pass to an outside;
a first microlens array configured to include a plurality of first microlenses formed on the pores of the first microaperture;
a second microlens array configured to include a plurality of second microlenses formed on the pores of the second microaperture; and
an image sensor supported through a spacer on a side of the second microaperture, and configured to detect light entering through the second microlens array and generate a corresponding electrical image signal,
wherein the second microlenses each refract light entering through the wafer to form a focus on the image sensor,
the first microlenses are cylindrical microlenses, and
the second microlenses are spherical microlenses or ellipsoidal microlenses.

12. The wide field-of-view camera device of claim 11, wherein
the cylindrical microlenses have refractive power in a specific direction, reducing astigmatism occurring at an angle of incidence greater than a certain level.

13. The wide field-of-view camera device of claim 11, wherein
a curvature of the first microlenses is configured such that the tangential focal length and the sagittal focal length are equal, to eliminate astigmatism.

14. The wide field-of-view camera device of claim 11, wherein
a field of view of each of the second microlenses is adjusted according to a size of the first microlenses, a distance between the first microaperture and the second microaperture, a diameter of the first microaperture, and a diameter of the second microaperture.

15. The wide field-of-view camera device of claim 11, wherein
the first microlenses of the first microlens array and the second microlenses of the second microlens array are arranged in either a circular arrangement or a rectangular arrangement, and
an arrangement pattern of the first microlenses and an arrangement pattern of the second microlenses are identical.

16. The wide field-of-view camera device of claim 15, wherein
no first microlens is formed on a central pore among the pores of the first microaperture, and
a microlens positioned farther from the central pore is larger than a microlens positioned relatively closer to the central pore.

17. A manufacturing method for a wide field-of-view camera device, comprising:
forming a first microaperture on a first surface of a wafer made of a transparent material capable of transmitting light, and forming a second microaperture on a second surface opposite to the first surface of the wafer wherein the first microaperture and the second microaperture each include one or more pores to allow light to pass through the wafer;
patterning a first thermoplastic photoresist on each one or more pores of the first microaperture, and patterning a second thermoplastic photoresist on each one or more pores of the second microaperture, wherein the first thermoplastic photoresist is not patterned in a central pore among the pores of the first microaperture;
forming the first microlenses using a thermal reflow process for the first thermoplastic photoresist, and forming the second microlenses using a thermal reflow process for the second thermoplastic photoresist; and
performing packaging the wide field-of-view camera device by attaching an image sensor to a side of the second microaperture of the wafer using a spacer,
wherein, in the packaging, the packaging is performed to form a focus on the image sensor by allowing the second microlenses each to refract light entering through the wafer,
the first microlenses are cylindrical microlenses, and
the second microlenses are spherical microlenses or ellipsoidal microlenses.

18. The manufacturing method of claim 17, wherein:
the forming includes depositing a metal layer on each of the first and second surfaces of the wafer, and forming the first microaperture and the second microaperture through a lift-off process for the metal layer.

19. The manufacturing method of claim 17, wherein
a curvature of the first microlenses is set such that a tangential focal length of each of the of first microlenses and a sagittal focal length of each of the first microlenses are the same.
